(19) Europäisches Patentamt
European Patent Office
Office européen des brevets

(11) Veröffentlichungsnummer : **0 046 861**
**B1**

(12) **EUROPÄISCHE PATENTSCHRIFT**

(45) Veröffentlichungstag der Patentschrift : **18.01.84**

(51) Int. Cl.³ : **C 09 K 11/06**, F 21 K 2/00// C09B57/06, H01L31/02

(21) Anmeldenummer : **81105559.9**

(22) Anmeldetag : **15.07.81**

(54) **Verfahren zur flächenmässigen Konzentrierung von Licht.**

(30) Priorität : **29.08.80 DE 3032546**

(43) Veröffentlichungstag der Anmeldung : **10.03.82 Patentblatt 82/10**

(45) Bekanntmachung des Hinweises auf die Patenterteilung : **18.01.84 Patentblatt 84/03**

(84) Benannte Vertragsstaaten : **CH DE FR GB IT LI**

(56) Entgegenhaltungen :
**EP-A- 0 004 655**
**DE-A- 2 851 513**
**DE-A- 2 930 333**
**US-A- 3 669 985**
**US-A- 3 733 334**
**US-A- 3 793 337**
**US-A- 4 164 432**
**Die Akte enthält technische Angaben, die nach dem Eingang der Anmeldung eingereicht wurden und die nicht in dieser Patentschrift enthalten sind.**

(73) Patentinhaber : **BASF Aktiengesellschaft**
**Carl-Bosch-Strasse 38**
**D-6700 Ludwigshafen (DE)**

(72) Erfinder : **Schefczik, Ernst, Dr.**
***Dubliner Strasse 7***
**D-6700 Ludwigshafen (DE)**
Erfinder : **Seybold, Guenther, Dr.**
**Friedrich-Ebert-Strasse 14**
**D-6701 Neuhofen (DE)**

**EP 0 046 861 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

Verfahren zur flächenmäßigen Konzentrierung von Licht

Die Erfindung betrifft ein Verfahren zur Konzentrierung von Licht mittels fluoreszierender Verbindungen.

Aus den DE-A 26 20 115 und 25 54 226 sind Vorrichtungen bekannt, in denen sichtbares Licht in einer Kunststoffplatte durch eingelagerte Fluoreszenzzentren auf eine kleine Fläche konzentriert werden kann.

Die in diesen Vorrichtungen als Fluoreszenzzentren benötigten Verbindungen müssen insbesondere im Falle der Umwandlung von Lichtenergie in elektrische Energie eine hohe Lichtechtheit aufweisen, damit die Vorrichtungen eine für die Anwendung ausreichende Lebensdauer aufweisen. D. h. die als Fluoreszenzzentren verwendeten Verbindungen müssen in den verwendeten Kunststoffen eine hohe Lichtechtheit aufweisen.

Aufgabe der vorliegenden Erfindung war es, für die bekannten Vorrichtungen zur Lichtkonzentrierung als Fluoreszenzzentren geeignete Verbindungen bereitzustellen, die eine hohe Fluoreszenz bei gleichzeitig hoher Lichtechtheit in dem verwendeten Medium aufweisen und die auf das Medium keine nachteilige Wirkung ausüben.

Es wurde gefunden, daß man bei der flächenmäßigen Konzentrierung von Licht mittels fluoreszierender Verbindungen in einer Kunststoffplatte hervorragende Ergebnisse erzielt, wenn man als fluoreszierende Verbindungen solche der allgemeinen Formel I

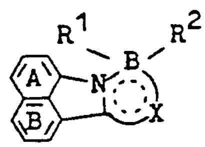 (I)

verwendet, in der

$R^1$ und $R^2$ unabhängig voneinander Acyloxy, Fluor oder gegebenenfalls substituiertes Aryl, wobei $R^1$ und $R^2$ auch verknüpft sein können und

X einen Rest der Formeln

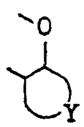 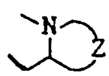 oder 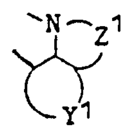

bedeuten, wobei die Ringe A und B noch substituiert sein können und Y, $Y^1$, Z und $Z^1$ die Ergänzung zu einem gegebenenfalls weiter anellierten carbocyclischen oder heterocyclischen 5- oder 6-Ring sind.

Verbindungen der Formel I oder die borfreien Vorprodukte sind größtenteils bekannt oder können nach analogen Verfahren hergestellt werden. Die Überführung der borfreien Vorprodukte in die Bor-Komplexe kann ebenfalls nach bekannten Methoden erfolgen. Für das erfindungsgemäße Verfahren geeignete Verbindungen der Formel I oder deren Vorprodukte sind beispielsweise in den DE-A 12 47 513, 15 69 692, 15 69 693, 23 09 612, 23 41 657, 23 57 442, 24 15 055, 26 03 592, 26 06 716, 26 08 020, 27 36 914, der US-A 37 33 334 sowie den Patentanmeldungen DE-A 24 28 198, 26 11 665, 27 05 108, C 29 24 067, C 29 30 333 und C 29 98 467.

Repräsentative Einzelverbindungen der Formel I sind z. B. :

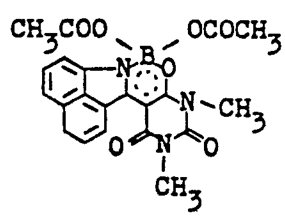

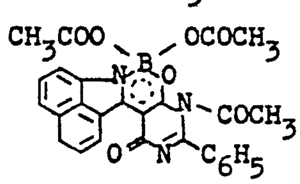

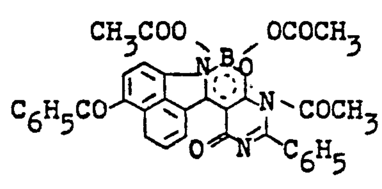

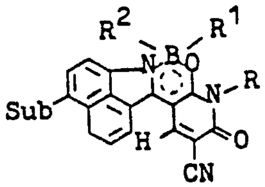

Sub = $C_6H_5CO$,

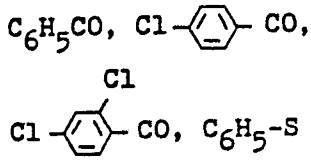

$C_6H_5$-S

$R^2$, $R^1$ = $OCOC_2$-bis $C_{10}$-Alkyl, F, $C_6H_5$

$R^2$ + $R^1$ =

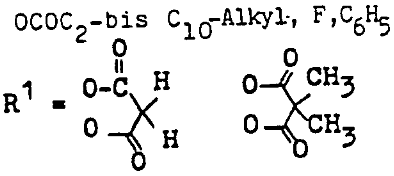

R = $CH_3$, $C_2H_5$, $C_4H_9$, $CH_2C_6H_5$

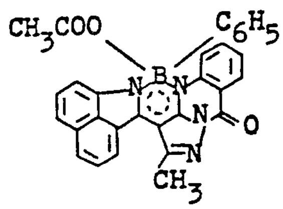

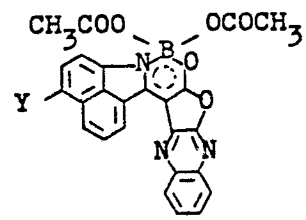

Y = $COC_6H_5$, $S-C_6H_5$, H, Cl, $SO_2CH_3$, $N(C_2H_5)_2$

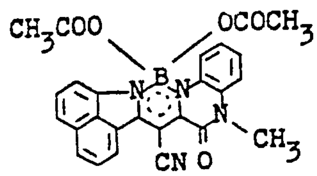

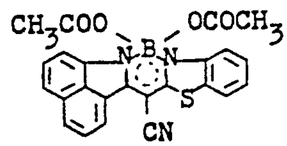

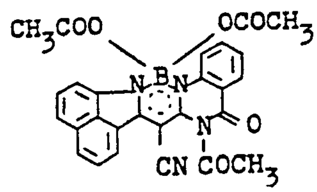

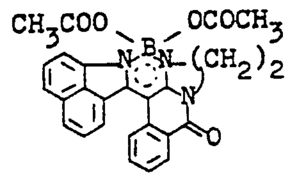

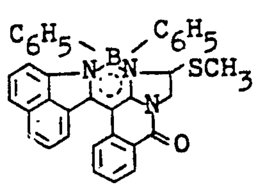

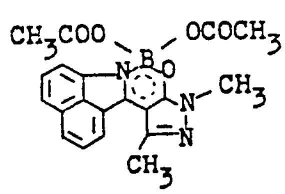

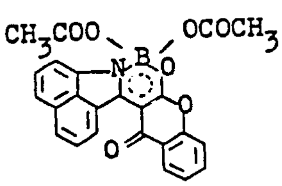

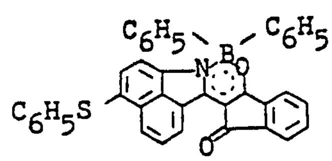

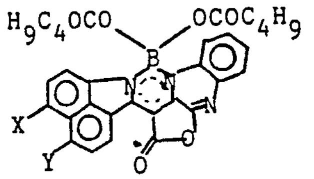

| X | Y |
|---|---|
| $S-C_6H_5$ | H |
| $O-CH_3$ | $OCH_3$ |
| Cl | Cl |
| $COC_6H_5$ | H |
| $SO_2CH_3$ | H |
| H | H |

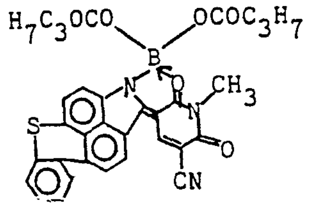

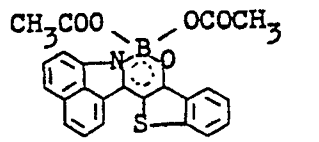

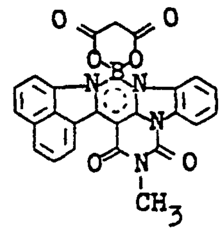

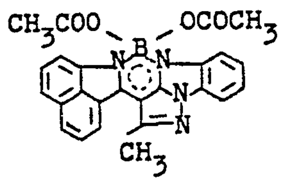

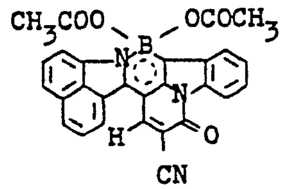

Die Verbindungen der Formel I sind in den für die Lichtkonzentrierung verwendeten Kunststoffplatten sehr lichtecht und wandeln eingestrahltes Licht in hohen Ausbeuten in Fluoreszenzlicht um. Die Wellenlänge des ausgestrahlten Fluoreszenzlichtes liegt zwischen 400 und 700 nm. Hervorzuheben ist der große Stokesshift, den man bei diesem Farbstofftyp antrifft. Damit wird die unerwünschte Reabsorption des Fluoreszenzlichtes auf ein Minimum beschränkt.

Zur Anwendung werden die Verbindungen (I) üblicherweise in Mengen von $10^{-5}$ bis $10^{-2}$ Mol/l in für die Anwendung geeigneten Kuntstoffen eingearbeitet. Hierzu wird der Kunststoff als Granulat mit der benötigten Menge an (I) bepudert und die Granulate dann zu Flächengebilden extrudiert. Außerdem lassen sich die Farbstoffe auch im Gießverfahren einarbeiten. Als Kunststoffe (Medium) kommen z. B. für eine Verwendung zur Lichtkonzentration für Solarzellen vorzugsweise Polymethylmethacrylat, Polymethylacrylat, Polystyrol, Polydiäthylenglykol-diallylbiscarbonat, ferner auch geeignete Polyamide und Polycarbonate in Betracht.

Die Erfindung soll durch die folgenden Beispiele weiter erläutert werden. Die im folgenden angegebenen Teile und Prozentangaben beziehen sich auf das Gewicht.

Beispiel 1

In geschmolzenem Polymethylmethacrylat werden 0,01 % des Farbstoffs der Formel

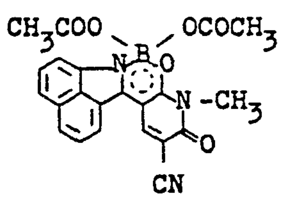

gelöst, homogen verteilt und zu Fluoreszenzplatten verarbeitet.

Absorption : 506 ; Emission : 594

Fluoreszenzquantenausbeute : 0,87 (in $HCCl_3$)

Beispiel 2

1 000 Teile Polymethylmethacrylatgranulat werden mit 0,05 Teilen des Farbstoffs der Formel

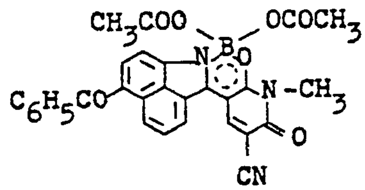

gleichmäßig bepudert. Die Mischung wurde anschließend zu Platten extrudiert.
Absorption : 460 nm ; Emission : 534 nm

Beispiel 3

In 1 000 Teilen Methylmethacrylat wurden 0,05 Teile des Farbstoffs

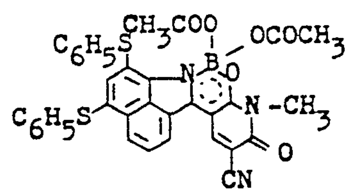

gelöst. Anschließend wird die Lösung in Formen gegossen und unter Zusatz eines Starters in bekannter Weise polymerisiert.
Absorption : 555 nm ; Emission : 654 nm

Beispiele 4-19

Entsprechend den Beispielen 1-3 wurden Fluoreszenzplatten mit folgenden Farbstoffen hergestellt :

| Beispiel Nr. | Farbstoff | Kunststoff | Absorpt./Emission (nm) |
|---|---|---|---|
| 4 | 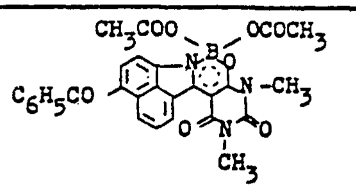 | Polymethylmethacrylat | 461/532 |
| 5 | 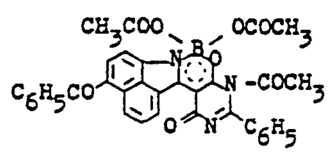 | " | 499/559 |
| 6 | 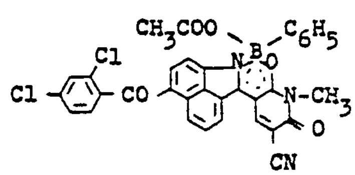 | " | 511/599 |
| 7 | " | Polyäthylenglykoldiallylbiscarbonat | 510/600 |
| 8 | 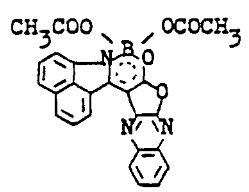 | Polymethylmethacrylat | 505/595 |

(Fortsetzung)

| Beispiel Nr. | Farbstoff | Kunststoff | Absorpt./Emission (nm) |
|---|---|---|---|
| 9 | 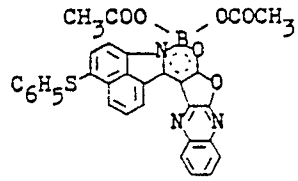 | Polymethyl-methacrylat | 540/640 |
| 10 | 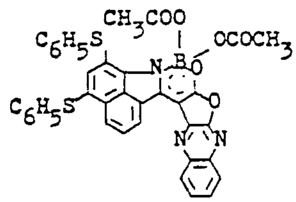 | " | 560/660 |
| 11 | 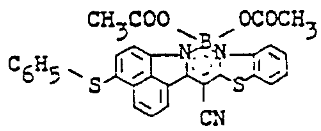 | " | 480/574 |
| 12 | 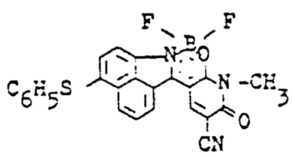 | " | Absorpt. 530 |
| 13 | 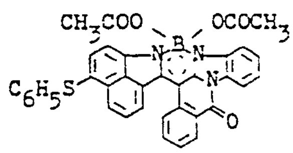 | " | " 577 |
| 14 | 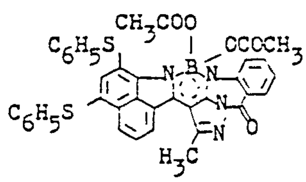 | " | " 555 |
| 15 | 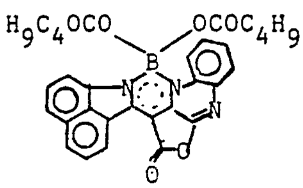 | Polymethyl-methacrylat | 506/596 |
| 16 | " | Polycarbonat | 506/596 |
| 17 | " | Polystyrol | 506/596 |
| 18 | " | Polystyrol/Acrylnitril-mischpolymerisat | 506/596 |
| 19 | 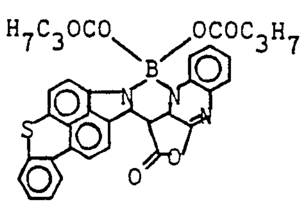 | " | 650/720 |

**Ansprüche**

1. Verfahren zur flächenmäßigen Konzentrierung von Licht mit Hilfe fluoreszierender Verbindungen, dadurch gekennzeichnet, daß man als fluoreszierende Verbindungen solche der allgemeinen Formel

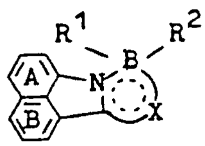

(I)

verwendet, in der

$R^1$ und $R^2$ unabhängig voneinander Acyloxy, Fluor oder gegebenenfalls substituiertes Aryl, wobei $R^1$ und $R^2$ auch verknüpft sein können und

X einen Rest der Formeln

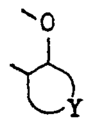

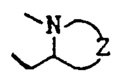

oder

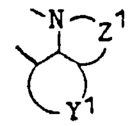

bedeuten, wobei die Ringe A und B noch substituiert sein können und Y, $Y^1$, Z und $Z^1$ die Ergänzung zu einem gegebenenfalls weiter anellierten carbocyclischen oder heterocyclischen 5- oder 6-Ring sind.

2. Verfahren gemäß Anspruch 1, dadurch gekennzeichnet, daß man Verbindungen gemäß Anspruch 1 verwendet, wobei X ein Rest der Formel

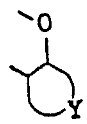

ist.

**Claims**

1. A process for concentrating light over an area with the aid of a fluorescing compound, wherein the fluorescing compound used is of the general formula

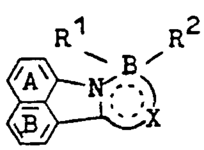

(I)

where

$R^1$ and $R^2$ independently of one another denote acyloxy, fluorine or optionally substituted aryl, it being possible for $R^1$ and $R^2$ to also be linked, and

X is a radical of the formula

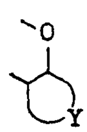

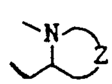

or

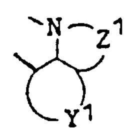

where rings A and B may be substituted, and Y, $Y^1$, Z and $Z^1$ complete a carbocyclic or heterocyclic 5- or 6-membered ring which may bear further fused rings.

2. A process as claimed in claim 1, wherein a compound as claimed in claim 1 is used, X being a radical of the formula

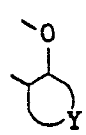

**Revendications**

1. Procédé pour la concentration en surface de la lumière à l'aide de composés fluorescents, caractérisé en ce que l'on utilise en tant que composés fluorescents les composés répondant à la formule générale

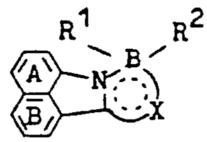

(I)

dans laquelle

$R^1$ et $R^2$ représentent chacun, indépendamment l'un de l'autre, un groupe acyloxy, le fluor ou un groupe aryle éventuellement substitué, $R^1$ et $R^2$ pouvant également être reliés entre eux, et

X représente un reste de formule

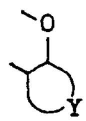 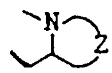 ou 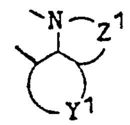

les cycles A et B pouvant encore être substitués et Y, $Y^1$, Z et $Z^1$ complétant un noyau carbocyclique ou hétérocyclique à 5 ou 6 chaînons éventuellement condensé.

2. Procédé selon la revendication 1, caractérisé en ce que l'on utilise des composés selon la revendication 1, dans lesquels X est un reste de formule